# EUROPEAN PATENT APPLICATION

(11) **EP 1 333 315 A1**
(43) Date of publication of application: **06.08.2003**
(21) Application number: 03001651.3
(22) Date of filing: 24.01.2003
(51) Int. Cl.: G02F 1/1335, G02B 5/20, G03F 7/00

(54) **Method of producing a colour filter array element using an embossed surface**

(30) Priority: 25.01.2002 JP 2002017067; 19.07.2002 JP 2002211120
(71) Applicant: Fuji Photo Film Co. Ltd., Kanagawa 250-0193 (JP)
(72) Inventor: Ryuchi, Katsumoto, Fujinomiya-shi, Shizuoka 418-8666 (JP); Ogawa, Shotaro, Fujinomiya-shi, Shizuoka 418-8666 (JP); Hodosawa, Yoshihito, Fujinomiya-shi, Shizuoka 418-8666 (JP); Nagano, Hideo, Fujinomiya-shi, Shizuoka 418-8666 (JP); Kegasawa, Tadahiro, Fujinomiya-shi, Shizuoka 418-8666 (JP)
(74) Representative: Klunker . Schmitt-Nilson . Hirsch

(57) **Abstract**

The present invention provides a method of producing a pattern member at high productivity and low cost. In the method of the present invention, inks of plural colors are applied on a substrate and dried to produce several kinds of single color films having color ink layers of plural colors formed on the surface, then, the single color film of R color is overlapped on the substrate, and the overlapped substrate and single color film are pressed by a pressing member having a convex portion of given pattern formed on the surface, to transfer parts corresponding to the pattern of the convex portion of the color ink layer to the substrate. The above-described operation is repeated at frequency corresponding to plural colors to form a multi-color pattern composed of color ink layers of plural colors of given pattern on the substrate.

## Description

### BACKGROUND OF THE INVENTION

### Field of the Invention

The present invention relates to a method and apparatus for producing a pattern member used as an electron display material such as color filters, organic EL (electroluminescence) and the like, and a pattern member thus produced. Here, the pattern member includes films and sheets of color filters and organic displays, and also includes transfer films and sheets for producing the above-mentioned color filters and organic displays.

### Description of the Related Art

Conventionally used as an electron display material such as LCD color filters, organic EL pixels and the like are pattern members having a micron order fine pattern in the form of stripe or matrix of single color or three colors such as, for example, R (red), G (green), B (blue) and the like formed on a glass substrate, sheet substrate, film and the like.

As the method of producing such a pattern member, methods as shown below have been suggested until now (those regarding color filter production methods are mainly listed).
1) Relief dyeing method: The surface of a substrate such as a sheet and the like is patterned into given form using a photosensitive resist, then, the sheet is immersed in a dyeing solution to be colored (for each of RGB, three times in total).
2) Pigment dispersing method: A photosensitive resist containing a dispersed pigment is applied on the surface of a substrate, and exposed and developed to form a pattern (for each of RGB, three times in total).
3) Vacuum deposition method: Coloring material particles are heated to be evaporated, and adhered to the masked surface of a sheet to form a pattern (for each of RGB, three times in total).
4) Inkjet method: Coloring inks of RGB three colors are sprayed in small amount at given position by an inkjet method to effect patterning.
5) Electrodeposition method: A transparent electrode is patterned in given form, and electrodeposition is repeated three times on this, to make a colored pattern.
6) Offset printing method: Ink containing a dispersed pigment is printed three times on the surface of a sheet by an offset printing method.

However, these methods have the following problems and none of them is admitted as a satisfactory production method.
1. A relief dyeing method, pigment dispersing method and electrodeposition method include a lot of processes and are not suitable for mass production.
2. With a vacuum deposition method, it is difficult to produce a pattern member of large area.
3. A vacuum deposition method needs large equipment cost.
4. In all of the above-mentioned six methods, it is necessary to add special chemicals such as a hardening resin and the like to ink, and development of recipe is necessary, and additionally, an influence exerted on the ability of an electron display by the special chemicals is worried.
5. With the inkjet method and offset printing method, it is difficult to obtain an ink layer having constant thickness.
6. With the offset printing method, it is difficult to keep high accuracy of positioning in forming patterns of respective colors.

A production method satisfactory particularly in the following points, among the above-mentioned problems, is desired. Namely, a first point is mass production by a cheap equipment with a small number of processes, and a second point is large degree of freedom in ink selection and no necessity to add special chemicals to ink.

As the production method approximately satisfying such conditions, Japanese Patent Application Laid-Open (JP-A) No. 9-90117 discloses a method in which, in forming three kinds of colored layers in given pattern on a sheet, unnecessary portions of a colored solidified film are removed by transferring from a dry film having a colored solidified film made of a resin composition containing a dispersed coloring material to an intaglio surface having a given pattern, then, the colored solidified film of given pattern remaining on the dry film is transferred onto a sheet, for each color.

However, this production method needs two processes: a process in which, after production of a dry film, further, unnecessary portions of a colored solidified film on a dry film are removed for each color, and a process in which a colored solidified film remaining on a dry film is transferred onto a sheet, and it is difficult to decrease production cost.

For solving the above-mentioned problems 1 to 6, JP-A No. 11-260549 discloses a pattern member production method in which "A light-heat conversion layer and a heat propagation layer are formed on a film, and on this is formed a cathode layer, then, a light-emitting layer is formed in superposition, further, a hole injectable adhesive layer is formed in superposition, then, the film-formed side of a film is pasted on a substrate having a stripe patterned ITO anode, then, the film rear surface side is irradiated by YAG laser selectively so as to form a cathode shape, to transfer the multiply-formed layers onto a substrate. Then, the film is removed, driving means is connected to the substrate onto which the multiply-formed layers have been transferred, and a sealing treatment is performed to obtain an organic EL display."

This pattern member production method of transfer mode is a dry process, therefore, damages by an organic solvent, water and the like are not given to an organic material constituting an organic electroluminescence element, and a highly precise pattern can be formed.

However, this transfer mode has the following problem. Namely, in this transfer mode, a transfer substrate and a supporting substrate for an organic electroluminescence element have to be closely adhered completely, at parts intended to be transferred, in the transferring operation, however, irregularity by a pattern-formed electrode layer, an organic material layer and the like are present on the surface of the supporting substrate, namely, this surface is not completely flat, consequently, a gap may be formed between the transfer substrate and the organic electroluminescence element, and transfer is not performed at a such gap part, resultantly, short-circuit between electrodes occurs at this part, causing a display defect and yield decrease.

For solving this problem, JP-A No. 2001-196168 discloses "A method of producing an organic electroluminescence element, comprising a process in which at least a first electrode layer is firmed on a supporting substrate, a process in which a material constituting an electroluminescence layer and/or a second electrode layer is formed as a transfer layer on a transfer substrate, a process in which the first electrode layer-formed surface of the supporting substrate and the transfer layer-formed surface on the transfer substrate are crimped by a crimping roller, and a process in which the transfer layer formed on the transfer substrate is transferred onto the first electrode layer-formed surface side of the supporting substrate."

However, since this method disclosed in JP-A No. 2001-196168 is a method in which, in producing a multi-color pattern member, a difference is made in film thickness of transfer layers of respective colors formed on a color transfer substrate of a plurality of colors, and transfer layers are transferred sequentially onto the supporting substrate based on the difference in film thickness, to form a multi-color pattern, there is a problem that control of the film thickness of a transfer layer is difficult, and if the difference in film thickness is not controlled to a given value, correct transfer cannot be conducted.

### SUMMARY OF THE INVENTION

In view of the above-mentioned conditions, the object of the present invention is to provide a method and apparatus for producing a pattern member at high productivity and low cost, and a pattern member thus produced.

The first production method of the methods of producing a pattern member according to the present invention for attaining the above-mentioned object comprises:
by applying a color ink on each of a plurality of films and drying the color ink, producing a plurality of single color films each having a different color of a plurality of colors and a color ink layer formed on a surface of each single color film; and
transferring a part of a color ink layer to a substrate to produce a pattern member having a multi-color pattern made of color inks of the plurality of colors formed on the substrate by repeating, at frequency corresponding to the number of the plurality of colors, an operation of overlapping one of the plurality of single color films having one color on the substrate such that a color ink layer of the single color film comes in contact with the substrate, and then, pressing the overlapped substrate and single color film by a pressing member having a convex portion of given pattern formed on its surface, to transfer a portion of the color ink layer corresponding to a pattern of the convex portion to the substrate.

According to the first method of producing a pattern member of the present invention, after production of a single color film corresponding to the dry film referred in the above-mentioned conventional example, a pattern member is produced only in the above-mentioned step of transferring a part of a color ink layer to a substrate transfer. According to the method of producing a pattern member of the present invention, a pattern member can be produced with a small number of processes, namely, at high productivity and low cost.

Here, the step of transferring a part of a color ink layer to a substrate includes a process of applying an ink of given color on the substrate by any application means selected from a die coater, bar coater, spin coater and gravure coater.

In the first method of producing a pattern member of the present invention, a multi-color pattern sheet can be produced at low cost by any of these application process.

The step of transferring a part of a color ink layer to a substrate may be a step in which transfer is conducted using a pressing member having a convex portion of a pattern in the form of stripe or matrix formed on its surface.

In the first method of producing a pattern member of the present invention, a pattern member of any of the above-mentioned forms can be produced at low cost.

For attaining the above-mentioned object, the present invention also provides an apparatus of producing a pattern member that has a multi-color pattern made of color inks of a plurality of colors on its surface by repeating, at frequency corresponding to the number of the plurality of colors, an operation of overlapping on a given substrate a plurality of single color films each having a different color of the plurality of colors and a color ink layer formed on its surface, to transfer the color ink layer on the single color film to the substrate, the apparatus comprising:
transferring means corresponding to the number of the plurality of colors, transferring the color ink layer of the single color film to the substrate, the transferring means being constituted of a patterning roll having a convex portion of given pattern formed on its surface and a facing roll placed facing the patterning roll so that the patterning roll and facing roll sandwich both the substrate and the single color film between them;
substrate feeding means sequentially feeding the substrate to the transfer corresponding to the number of the plurality of colors; and
single color film feeding means corresponding to the number of the plurality of colors, feeding a single color film of one color among the single color films of the plurality of colors, between the patterning roll and the substrate fed to a nip portion sandwiched by the patterning roll and the facing roll, such that the color ink layer of the single color film overlaps on and comes in contact with the substrate.

The apparatus of producing a pattern member of the present invention, by this constitution, can realize an apparatus capable of producing a pattern member at low cost with a small number of processes.

The second production method of the methods of producing a pattern member of the present invention for attaining the above-mentioned object comprises the steps of:
forming a plurality of single color transfer materials each having one of a plurality of colors, by forming a coloring material layer of each color on each of a plurality of transfer substrates;
forming a pattern by a process in which each surface of the single color transfer materials of the plurality of colors is pressed by a pressing member having irregularity of given pattern formed on its surface, to form an irregularity pattern corresponding to the irregularity of the pressing member on the surface of the single color transfer material; and
transferring a part of the coloring material layer to the transfer substrate to produce a pattern member having a multi-color pattern of the plurality of colors on the substrate by repeating, at frequency corresponding to the number of the plurality of colors , an operation in which the surface of the single color transfer material of one color among the single color transfer materials of a plurality of colors having an irregularity pattern formed is overlapped on a given substrate and the coloring material layer at the convex portion of the single color transfer material is transferred to the substrate.

According to the second method of producing a pattern member of the present invention, owing to the above-mentioned constitution, a pattern member having a fine pattern can be produced at high productivity and low cost.

Here, the step of forming a plurality of single color transfer materials may be a step in which a plastic deformation layer is formed on each of the above-mentioned plurality of transfer substrates, and a coloring material layer of each color is formed on the plastic deformation, to form a single color transfer material of a plurality of colors.

When thus constituted, formation of an irregular pattern is easy due to the presence of a plastic deformation layer, therefore, a pattern member can be produced at further higher productivity and lower cost.

The step of forming a plurality of single color transfer materials may be a step in which the above-mentioned plastic deformation layer and the above-mentioned coloring material layer are overlapped and formed simultaneously.

When thus constituted, the number of processes can be decreased, therefore, a pattern member can be produced at further higher productivity and lower cost.

The step of forming a plurality of single color transfer materials may be a step in which a releasing layer is formed between the plastic deformation layer and coloring material layer of each color.

When thus constituted, transfer of a coloring material layer to a substrate is easy, therefore, a pattern member can be produced at further higher productivity and lower cost.

Further, the step of forming a plurality of single color transfer materials may be a step in which the plastic deformation layer, the releasing layer and the coloring material layer are overlapped and formed simultaneously.

When thus constituted, a pattern member can be produced at further higher productivity and lower cost.

The above-mentioned substrate is preferably a transparent substrate.

When thus constituted, a transparent pattern member can be produced at high productivity and low cost.

Also, the substrate is preferably a substrate obtained by forming an electrode layer on a transparent substrate.

When thus constituted, a pattern member having an electrode layer on its surface can be produced at high productivity and low cost.

As described above, in the second method of producing a pattern member of the present invention, only a coloring material layer may be formed on a substrate, a coloring material layer and plastic deformation layer may be formed on a substrate, or a coloring material layer, releasing layer and plastic deformation layer may be formed on a substrate, further, a coloring material layer and releasing layer may be formed on a substrate.

Further, the first pattern member of the pattern members of the present invention is a pattern member having a multi-color pattern made of color inks of a plurality of colors on a substrate, formed by repeating, at frequency corresponding to the number of the plurality of colors, an operation of overlapping a single color film of one color among single color films of a plurality of colors having a color ink layer formed on its surface by applying color inks of respective colors on a plurality of films and drying the color inks, on a given substrate such that the color ink layer of the single color film comes in contact with the substrate, and then, pressing the overlapped substrate and the single color film by a pressing member having a convex portion of given pattern formed on its surface, to transfer a portion corresponding to the pattern of the convex portion of the color ink layer to the substrate.

Still further, the second pattern member of the pattern members of the present invention is a pattern member having a multi-color pattern composed of a plurality of colors on a substrate, formed by repeating, at frequency corresponding to the number of the plurality of colors, an operation of pressing a surface of each single color transfer material having one of the plurality of colors formed by forming a coloring material layer of each color on each of a plurality of transfer materials, by a pressing member having irregularity of given pattern formed on its surface, to form an irregularity pattern corresponding to the irregularity of the pressing member on the surface of the single color transfer material, and then, overlapping the surface of the single color transfer material of one color among the single color transfer materials of the plurality of colors having an irregularity pattern formed on a given substrate, to transfer the coloring material layer at the convex portion of the single color transfer material to the substrate.

According to the first and second pattern members owing to the above-mentioned constitution, a pattern member can be obtained, at high productivity and low cost.

### BRIEF DESCRIPTION OF THE DRAWINGS

Figs. 1 to 4 are process views showing one embodiment of the method of producing a multi-color pattern sheet of the present invention.
Fig. 5 is a view showing a pattern in the form of stripe of a multi-color pattern sheet according to the present embodiment.
Fig. 6 is a view showing a pattern in the form of matrix of a multi-color pattern sheet of the present embodiment.
Figs. 7 to 10 are schematic views according to various application modes adopted in the present embodiment.
Fig. 11 is a schematic constitutional view showing one embodiment of the multi-color pattern sheet production apparatus of the present invention.
Fig. 12 is a sectional view along the rotation axis direction of a patterning roll in the present embodiment.
Fig. 13 is a part of a schematic process view showing the first embodiment of the second method of producing a pattern member of the present invention.
Fig. 14 is a part of a schematic process view showing the first embodiment of the second method of producing a pattern member of the present invention.
Fig. 15 is a part of a schematic process view showing the first embodiment of the second method of producing a pattern member of the present invention.
Fig. 16 is a part of a schematic process view showing the first embodiment of the second method of producing a pattern member of the present invention.
Fig. 17 is a part of a schematic process view showing the first embodiment of the second method of producing a pattern member of the present invention.
Fig. 18 is a part of a schematic process view showing the first embodiment of the second method of producing a pattern member of the present invention.
Fig. 19 is a part of a schematic process view showing the first embodiment of the second method of producing a pattern member of the present invention.
Fig. 20 is a part of a schematic process view showing the second embodiment of the second method of producing a pattern member of the present invention.
Fig. 21 is a part of a schematic process view showing the second embodiment of the second method of producing a pattern member of the present invention.
Fig. 22 is a part of a schematic process view showing the second embodiment of the second method of producing a pattern member of the present invention.
Fig. 23 is a part of a schematic process view showing the second embodiment of the second method of producing a pattern member of the present invention.

### DETAILED DESCRIPTION OF THE PREFERRED EMBODIMENTS

Here, a method of producing an organic thin film element utilizing the pattern member production method of the present invention will be described, then, an organic thin film layer transfer material will be described, further, an organic thin film element will be described.

### [1] Method of producing organic thin film element

A method of producing an organic thin film element of the present embodiment comprises a process in which a plurality of transfer materials formed by forming an organic thin film layer on a temporary substrate are used and an organic thin film layer is transferred onto a substrate according to a releasing transfer method, and a process in which a substrate carrying at least one of an electrode, transparent conductive layer and organic thin film layer formed is pasted on the organic thin film layer provided by a releasing transfer method.

The releasing transfer method is a transfer method in which a transfer material is heated and/or pressed to soften an organic thin film layer and adhered on a film forming surface of a substrate, then, a temporary supporting body is released to leave only the organic thin film layer on the film forming surface. The pasting method is a method in which the interfaces of at least two surfaces are connected by close adhesion, crimping, fusion and the like.
Specifically, this is a method in which an organic thin film layer transferred on a film forming surface, and a substrate having at least one of an electrode, transparent conductive layer and organic thin film layer formed, are overlapped, then, heated and/or pressed to soften the organic thin film layer which is adhered to the substrate having at least one of an electrode, transparent conductive layer and organic thin film layer formed. In the transfer method and pasting method used in the present embodiment , heating and pressing may be used singly or in combination.

As the heating means, known methods can generally be used, and for example, a laminator, infrared heater, roller heater, laser, thermal head and the like can be used. When transfer of large area is conducted, sheet heating means are preferable, and a laminator, infrared heater, roller heater and the like are more preferable. The transfer temperature is not particularly restricted, and can be changed depending on the material of an organic thin film layer and on a heating member, and in general, the temperature is preferably from 40 to 250°C, further preferably from 50 to 200°C, particularly from 60 to 180°C. The preferable temperature range for transfer relates to the heat resistance of a heating member, transfer material and substrate, and when the heat resistance increases, the range changes according to the increase.

Though the pressing means is not particularly restricted, when a substrate liable to be broken by strain such as glass and the like is used, the pressing means that performs pressing uniformly is preferred. For example, it is preferable to use couple rollers one or both of which are made of rubber, and specifically, laminators (Fast Laminator VA-400III (manufactured by Taisei Laminator K.K.) and the like), thermal heads for heat transfer printing, and the like can be used.

In the present embodiment, it is also possible to conduct transfer and releasing processes repeatedly to laminate a plurality of organic thin film layers on a substrate. The plurality of organic thin film layers may have the same composition or different compositions. In the case of the same composition, there is a merit that lack of a layer due to poor transfer or poor releasing can be prevented. In the case of layers of different compositions, there can be provided a design by which functions are separated to improved light emitting efficiency, for example, transparent conductive layer/light emitting organic thin film layer/electron transporting organic thin film layer/electron injection layer/backface electrode, transparent conductive layer/hole injection layer/hole transporting organic thin film layer/light emitting organic thin film layer/electron transporting organic thin film layer/electron injection layer/backface electrode, can be laminated on a film forming surface by the transfer method of the present embodiment. Regarding the transfer temperature in this procedure, it is preferable that temperature for heating a prior transfer material is higher than temperature for heating the next transfer material such that a prior transfer layer is not reverse-transferred to the next transfer layer.

It is preferable, if necessary, to conduct re-heating on an organic thin film layer transferred to a substrate, or on an organic thin film layer transferred onto the previously transferred organic thin film layer. By re-heating, an organic thin film layer is adhered more closely to a substrate or previously transferred organic thin film layer. It is preferable, if necessary, to conduct pressing in re-heating. The re-heating temperature is preferably in the range of the transfer temperature ± 50° C.

A surface treatment for improving close adhesive force may be performed on a film forming surface between a prior transfer process and the next transfer process such that a prior transfer layer is not reverse-transferred to the next transfer layer. As such a surface treatment, for example, activation treatments such as a corona discharge treatment, flame treatment, glow discharge treatment, plasma treatment and the like are listed. When a surface treatment is used together, it may be permissible that the transfer temperature of a prior transfer material is lower than the transfer temperature of the next transfer material as long as no reverse-transfer occurs.

As the apparatus of producing an organic thin film element, an apparatus of feeding a transfer material obtained by forming an organic thin film layer on a temporary supporting body, an apparatus of pressing a transfer material while heating to the film forming surface of a substrate to transfer an organic thin film layer to the film forming surface of a substrate, and an apparatus of peeling the temporary supporting body from the organic thin film layer after transfer, can be used.

The production apparatus used in the present embodiment preferable has means of pre-heating a transfer material and/or substrate before feeding to a transfer apparatus. Further, it is preferable that a cooling apparatus is contained in the latter stage of the transfer apparatus.

It is preferable that an approach angle controlling portion for controlling the approach angle to a substrate of a transfer material to 90° or less, is provided in front of a transfer apparatus. Further, it is preferable that a releasing angle controlling portion for controlling the releasing angle to an organic thin film layer of a temporary supporting body to 90° or more, is provided at the rear surface of a transfer apparatus or cooling apparatus. Details of these organic thin film element production methods and apparatuses are described in JP-A No. 2001-089663, and the like.

### [2] Transfer material

### (1) Constitution

As the transfer material, that having an organic thin film layer on a temporary supporting body is used. The transfer material can be produced appropriately using a known method, and it is preferable to use a wet method from the standpoint of productivity. Transfer materials having an organic thin film layer provided may be produced individually as an independent transfer material or may be produced in the surface order. Namely, it may also be permissible that a plurality of organic thin film layers are provided on one temporary supporting body. If this transfer material is used, a plurality of organic thin film layers can be formed continuously without requiring exchange of the transfer material.

Further, if a transfer material obtained by previously laminating two or more organic thin film layers on a temporary supporting body is used, a multi-layer film can be laminated on the film forming surface of a substrate in one transfer process. When previous lamination is conducted on a temporary supporting body, if the interface of each organic thin film layer laminated is not uniform, movement of holes and electrons becomes irregular. Therefore, it is necessary to deliberately select a solvent for uniformalizing the interface and it is necessary to select an organic compound for the organic thin film layer soluble in its solvent.

### (2) Temporary supporting body

The temporary supporting body used in the present embodiment should be constituted of a material stable chemically and thermally and having flexibility, and specifically preferable are thin sheets made of fluorine resins [for example, ethylene tetrafluoride resin (PTFE), ethylene trifluoride chloride resin (PCTFE)], polyesters (for example, polyethylene terephthalate, polyethylene naphthalate (PEN)), polyarylates, polycarbonates, polyolefins (for example, polyethylene, polypropylene), polyether sulfone (PES) and the like, and laminates of them. The thickness of a temporary supporting body is suitably from 1 µm to 100 µm, further preferably from 2 µm to 50 µm, particularly preferably from 3 µm to 30 µm.

### (3) Formation of organic thin film layer on temporary supporting body

An organic thin film layer containing a polymer compound as a binder is preferably formed on a temporary supporting body by a wet method. For this, a material for organic thin film layer is dissolved in an organic solvent to give desired concentration, and the resulted solution is applied on a temporary supporting body. The application method is not particularly restricted as long as the dry film thickness of an organic thin film layer is 200 nm or less and uniform film thickness distribution is obtained, and includes a spin coat method, gravure coat method, die coat method, bar coat method and the like.

### (4) Organic thin film layer

The organic thin film layer is a layer constituting an organic thin film element, and examples thereof include a light emitting organic thin film layer, electron transporting organic thin film layer, hole transporting organic thin film layer, electron injection layer, hole injection layer and the like from the standpoint of their properties. The organic thin film layer does not have a light-heat conversion layer (layer capable of performing light-heat conversion by laser). Further, there are various layers for improving a color developing property. Specific examples of the compound used in each layer are described in, for example, "Monthly Display", October 1998, separate volume "Organic EL Display" (published by Techno Times Co.Ltd), and the like.

The glass transition temperature of an organic thin film layer itself or components in this is preferably not lower than 40° C and not higher than the transition temperature +40° C, further preferably not lower than 50° C and not higher than the transition temperature +20° C, particularly preferably not lower than 60°C and not higher than the transition temperature. The flow initiation temperature of an organic thin film layer itself in a transition material or components in this is preferably not lower than 40°C and not higher than the transition temperature +40°C, further preferably not lower than 50°C and not higher than the transition temperature +20° C, particularly preferably not lower than 60° C and not higher than the transition temperature. The glass transition temperature can be measured by a differential scanning calorimeter (DSC). The flow initiation temperature can be measured using Flow Testor CFT-500 manufactured by Shimadzu Corporation.

### (a) Light emitting organic thin film layer

As the light emitting organic thin film layer, that containing at least one kind of light emitting compound is used. The light emitting compound is not particularly restricted, may be a fluorescence emitting compound or a phosphorescence emitting compound. Alternatively, a fluorescence emitting compound and a phosphorescence emitting compound may be used simultaneously. In the present embodiment, it is preferable to use a phosphorescence emitting compound from the standpoints of light emitting brilliance and light emitting efficiency.

As the phosphorescence emitting compound, benzooxazole derivatives, benzimidazole derivatives, benzothiazole derivatives, styrylbenzene derivatives, polyphenyl derivatives, diphenylbutadiene derivatives, tetraphenylbutadiene derivatives, naphthalimide derivatives, coumarin derivative, perylene derivatives, perynone derivatives, oxadiazole derivatives, aldazine derivatives, pyralidine derivatives, cyclopentadiene derivatives, bisstyrylanthracene derivatives, quinacridone derivatives, pyrrolopyridine derivatives, thiadiazolopyridine derivatives, styrylamine derivatives, aromatic dimethylidene compounds, metal complexes (metal complexes of 8-quinolinol derivatives, rare earth metal complexes, and the like), polymer light emitting compounds (polythiophene derivatives, polyphenylene derivatives, polyphenylenevinylene derivatives, polyfluorene derivatives and the like) and other compounds can be used. These may be used singly or in admixture of two or more.

The phosphorescence emitting compound is preferably a compound capable of emitting light from the triplet excited state, and preferable are orthometalated complexes and porphyrin complexes. Of porphyrin complexes, a porphyrin platinum complex is preferable. The phosphorescence emitting compounds may be used alone or in combination of two or more.

The orthometalated complex referred to in the present embodiment is a generic name for the group of compounds described in Akio Yamamoto, "Organic Metal Chemistry, Base and Application (Yuki Kinzoku Kagaku, Kiso to Oyo)", pp. 150 and 232, published by Shokabo (1982), H. Yersin, "Photochemistry and Photophysics of Coordination Compounds", pp. 71 to 77 and 135 to 146, Springer-Verlag (1987) and the like. The ligand forming the orthometalated complex is not particularly restricted, and preferably a 2-phenylpyridine derivative, 7,8-benzoquinoline derivative, 2-(2-thienyl)pyridine derivative, 2-(1-naphthyl)pyridine derivative or 2-phenylquinoline derivative. These derivatives may have a substituent. In addition to ligands essential for forming these orthometalated complexes, other ligands may be present. As the center metal forming the orthometalated complex, any transition metal can be used, and in the present embodiment, rhodium, platinum, gold, iridium, ruthenium, palladium and the like can be preferably used. An organic thin film layer containing such an orthometalated complexis excellent in light emitting brilliance and light emitting efficiency. The orthometalated complex is described specifically in Japanese Patent Application No. 2000-254171.

The orthometalated complex used in the present embodiment can be synthesized by known methods described in Inorg. Chem., 30, 1685, 1991, Inorg. Chem., 27, 3464, 1988, Inorg. Chem., 33, 545, 1994, Inorg. Chim. Acta, 181, 245, 1991, J. Organomet. Chem., 335, 293, 1987, J. Am. Chem. Soc., 107, 1431, 1985 and the like.

The content of a light emitting compound in a light emitting organic thin film layer is not particularly restricted, and for example, preferably from 0.1 to 70 wt%, more preferably from 1 to 20 wt%. When the content of a light emitting compound is less than 0.1 wt% or over 70 wt%, its effect may not be sufficiently manifested.

The light emitting organic thin film layer may contain host compounds, hole transporting materials, electron transporting materials, electrically inactive polymer binders and the like, if necessary. Functions of these materials can be attained simultaneously by one compound in some cases. For example, a carbazole derivative functions not only as a host compound but also as a hole transporting compound.

The host compound is a compound causing energy movement from its excited state to a light emitting compound, resultantly to cause light emission of this light emitting compound. Specific examples thereof include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, anthraquinodimethane derivatives, anthrone derivatives, diphenylquinone derivatives, thiopyranedioxide derivatives, carbodiimide derivatives, fluorenylidenemethane derivatives, distyrylpyrazine derivatives, heterocyclic tetracarboxylic anhydrides such as naphthaleneperylene and the like, phthalocyanine derivatives, metal complexes of 8-quinolinol derivatives, metal complexes having as a ligand metalphthalocyanine, benzooxazole, benzothiazole and the like, polysilane compounds, poly(N-vinylcarbazole) derivatives, conductive polymers such as aniline copolymers, thiophene oligomers, polythiophene and the like, polythiophene derivatives, polyphenylene derivatives, polyphenylenevinylene derivatives, polyfluorene derivatives and the like. The host compound may be used alone or in combination of two or more. The content of the host compound in a light emitting organic thin film layer is preferably from 0 to 99.9 wt%, more preferably from 0 to 99.0 wt%.

The hole transporting material is not particularly restricted as long as it has any of a function of injecting a hole from an anode, a function of transporting a hole and a function of blocking an electron injected from a cathode, and may be a low molecular weight material or high molecular weight material. Specific examples thereof include carbazole derivatives, triazole derivatives, oxazole derivatives, oxadiazole derivatives, imidazole derivatives, polyarylalkane derivatives, pyrazoline derivatives, pyrazolone derivatives, phenylenediamine derivatives, arylamine derivatives, amino-substituted chalcone derivatives, styrylanthracene derivatives, fluorenone derivatives, hydrazone derivatives, stilbene derivatives, silazane derivatives, aromatic tertiary amine compounds, styrylamine compounds, aromatic dimethylidene compounds, porphyrin compounds, polysilane compounds, poly(N-vinylcarbazole) derivatives, conductive polymers such as aniline copolymers, thiophene oligomers, polythiophene and the like, polythiophene derivatives, polyphenylene derivatives, polyphenylenevinylene derivatives, polyfluorene derivatives and the like. These may be used alone or in combination of two or more. The content of the hole transporting material in a light emitting organic thin film layer is preferably from 0 to 99.9 wt%, more preferably from 0 to 80.0 wt%.

The electron transporting material is not particularly restricted as long as it has any of a function of injecting an electron from a cathode, a function of transporting an electron and a function of blocking a hole injected from an anode. Specific examples thereof include triazole derivatives, oxazole derivatives, oxadiazole derivatives, fluorenone derivatives, anthraquinodimethane derivatives, anthrone derivatives, diphenylquinone derivatives, thiopyranedioxide derivatives, carbodiimide derivatives, fluorenylidenemethane derivatives, distyrylpyrazine derivatives, heterocyclic tetracarboxylic anhydrides such as naphthaleneperylene and the like, phthalocyanine derivatives, metal complexes of 8-quinolinol derivatives, metal complexes having as a ligand metalphthalocyanine, benzooxazole, benzothiazole and the like, conductive polymers such as aniline copolymers, thiophene oligomers, polythiophene and the like, polythiophene derivatives, polyphenylene derivatives, polyphenylenevinylene derivatives, polyfluorene derivatives and the like. These may be used alone or in combination of two or more. The content of the electron transporting material in a light emitting organic thin film layer is preferably from 0 to 99.9 wt%, more preferably from 0 to 80.0 wt%.

As the polymer binder, polyvinyl chloride, polycarbonate, polystyrene, polymethyl methacrylate, polybutyl methacrylate, polyester, polysulfone, polyphenylene oxide, polybutadiene, hydrocarbon resin, ketone resin, phenoxy resin, polyamide, ethylcellulose, vinyl acetate, ABS resin, polyurethane, melamine resin, unsaturated polyester, alkyd resin, epoxy resin, silicone resin, polyvinylbutyral, polyvinylacetal and the like can be used. These may be used alone or in combination of two or more. A light emitting organic thin film layer containing a polymer binder can be easily formed by application in large area by a wet film forming method.

The thickness of a light emitting organic thin film layer is preferably from 10 nm to 200 nm, more preferably from 20 nm to 80 nm. When the thickness is over 200 nm, driving voltage may increase. On the other hand, when less than 10 nm, an organic thin film element may form a short circuit.

### (b) Hole transporting organic thin film layer

The organic thin film layer may have a hole transporting organic thin film layer composed of the above-mentioned hole transporting material, if necessary. The hole transporting organic thin film layer may contain the above-mentioned polymer binder. The thickness of the hole transporting organic thin film layer is preferably from 10 nm to 200 nm, more preferably from 20 nm to 80 nm. When the thickness is over 200 nm, driving voltage may increase, and when less than 10 nm, an organic thin film element may give a short circuit.

### (c) Electron transporting organic thin film layer

The organic thin film element may have an electron transporting organic thin film layer composed of the above-mentioned electron transporting material, if necessary. The electron transporting organic thin film layer may contain the above-mentioned polymer binder. The thickness of the electron transporting organic thin film layer is preferably from 10 nm to 200 nm, more preferably from 20 nm to 80 nm. When the thickness is over 200 nm, driving voltage may increase, and when less than 10 nm, an organic thin film element may give a short circuit.

When an organic thin film layer is formed by application by a wet film forming method, a solvent used to dissolve a material of an organic thin film layer to prepare an application solution is not particularly restricted, and can be appropriately selected depending on the kind of the hole transporting material, orthometalated complex, host compound, polymer binder and the like. Exemplified are halogen-based solvents (chloroform, carbon tetrachloride, dichloromethane, 1,2-dichloroethane, chlorobenzene and the like), ketone-based solvents (acetone, methyl ethyl ketone, diethylketone, n-propyl methyl ketone, cyclohexanone and the like), aromatic solvents (benzene, toluene, xylene and the like), ester-based solvents (ethyl acetate, n-propyl acetate, n-butyl acetate, methyl propionate, ethyl propipnate, γ-butyrolactone, diethyl carbonate and the like), ether-based solvents (tetrahydrofuran, dioxane, and the like), amide-based solvents (dimethylformamide, dimethylacetamide and the like), dimethyl sulfoxide, water and the like. The solid content in an application solution for organic thin film layer is not particularly restricted, and its viscosity can also be optionally selected depending on a wet film forming method.

When a plurality of organic thin film layers are formed, dry film forming methods such as a vapor deposition method, sputter method and the like, wet film forming methods such as dipping, spin coat method, dip coat method, cast method, die coat method, roll coat method, bar coat method, gravure coat method and the like, printing methods, and the like can also be used together, in addition to a transfer method.

### [3] Organic thin film element

### (1) Constitution

The whole constitution of the organic thin film element may be a constitution in which transparent conductive layer/light emitting organic thin film layer/backface electrode, transparent conductive layer/light emitting organic thin film layer/electron transporting organic thin film layer/backface electrode, transparent conductive layer/hole transporting organic thin film layer/light emitting organic thin film layer/electron transporting organic thin film layer/backface electrode, transparent conductive layer/hole transporting organic thin film layer/light emitting organic thin film layer/backface electrode, transparent conductive layer/light emitting organic thin film layer/electron transporting organic thin film layer/electron injection layer/backface electrode, transparent conductive layer/hole injection layer/hole transporting organic thin film layer/light emitting organic thin film layer/electron transporting organic thin film layer/electron injection layer/backface electrode, and the like are laminated in this order on a substrate supporting body, a constitution of reverse lamination of them, and the like. The light emitting organic thin film layer contains a fluorescence emitting compound and/or phosphorescence emitting compound, and usually, light emission is derived from a transparent conductive layer. Specific examples of the compound used in each layer are described in, for example, "Monthly Display", October 1998, separate volume "Organic EL Display" (published by Techno Times Co. Ltd), and the like.

### (2) Substrate supporting body

The substrate supporting body may be made of an inorganic material such as yttrium stabilized with zirconia (YSZ), glass and the like, polyester such as polyethylene terephthalate, polybutylene terephthalate, polyethylene naphthalate and the like, polymer material such as polystyrene, polycarbonate, polyether sulfone, polyarylate, allyl diglycol carbonate, polyimide, polycycloolefin, norbornene resin, polychlorotrifluoroethylene, Teflon (trade mark), polytetrafluoroethylene-polyethylene copolymer and the like, metal foil such as aluminum foil, copper foil, stainless foil, gold foil, silver foil and the like, polyimide, plastic sheet of liquid crystal polymer, and the like. In the present embodiment, it is preferable to use a flexible substrate supporting body since it is not easily broken, is easily bended, and is light, and the like. Preferable as the material forming such a substrate supporting body are polyimides, polyesters, polycarbonates, polyether sulfone, metal foils (aluminum foil, copper foil, stainless foil, gold foil, silver foil and the like), plastic sheets of liquid crystalline polymers, polymer materials containing a fluorine atom (polychlorotrifluoroethylene, Teflon (trade mark), polytetrafluoroethylene-polyethylene copolymer, and the like) and other compounds, excellent in heat resistance, dimension stability, solvent resistance, electric insulation property and processability and having low gas permeability and low hygroscopicity.

The form, structure, size and the like of the substrate supporting body can be appropriately selected depending on the object and application of an organic thin film element. The form is plate in general. The structure may be a single layer structure or a laminated structure. The substrate supporting body may be formed of a single member or of two or more members. As the substrate supporting body, any of a transparent body and a non-transparent body can be used. However, when light emission is derived from the supporting body side since a transparent electrode described below is situated at the substrate supporting body side against an organic layer containing a light emitting layer, and the like, it is preferable that the substrate supporting body is colorless and transparent or colored and transparent, and from the standpoint of suppression of scattering and attenuation of light, colorless and transparent is preferable.

As the flexible substrate supporting body which does not give a short circuit in forming an electrode to produce a light emitting element, a substrate supporting body provided with an insulation layer on one or both surfaces of a metal foil is preferable. The metal foil is not particularly restricted, and a metal foil such as an aluminum foil, copper foil, stainless foil, gold foil, silver foil and the like can be used. Of them, from the standpoints of easiness in processing and cost, an aluminum foil or a copper foil is preferable. The insulation layer is not particularly restricted, and can be formed of, for example, an inorganic substance such as inorganic oxides, inorganic nitrides and the like, a polyester such as polyethylene terephthalate, polybutylene phthalate, polyethylene naphthalate and the like, a plastic such as polystyrene, polycarbonate, polyether sulfone, polyarylate, allyl diglycol carbonate, polyimide, polycycloolefin, norbornene resin, poly(chlorotrifluoroethylene), polyimide and the like.

The substrate supporting body has a coefficient of linear expansion by heat, preferably 20 ppm/°C or less. The coefficient of linear expansion by heat is measured by a method in which a sample is heated at constant speed and change in length of the sample is detected, and mainly, it is measured by TMA method. When the coefficient of linear expansion by heat is over 20 ppm/°C, becomes a cause for peeling of an electrode and organic thin film layer due to heat and the like in a pasting process or in use, and the like and becomes a cause for deterioration in durability.

The coefficient of linear expansion by heat of an insulation layer provided on a substrate supporting body is also preferably 20 ppm/°C or less. As the material forming an insulation layer having a coefficient of linear expansion by heat of 20 ppm/°C or less, metal oxides such as silicon oxide, germanium oxide, zinc oxide, aluminum oxide, titanium oxide, copper oxide and the like, and metal nitrides such as silicon nitride, germanium nitride, aluminum nitride and the like, are preferable, and these can be used alone or in combination of two or more. The thickness of the inorganic insulation layer made of a metal oxide and/or metal nitride is preferably from 10 nm to 1000 nm. When the inorganic insulation layer is thinner than 10 nm, an insulation property is too low. When the inorganic insulation layer is thicker than 1000 nm, crack tends to occur, and pin holes are formed to decrease an insulation property. The method of forming the insulation layer made of a metal oxide and/or metal nitride is not particularly restricted, and dry methods such as a vapor deposition method, sputtering method, CVD method and the like, wet methods such as a sol-gel method and the like, a method in which particles of a metal oxide and/or metal nitride are dispersed in a solvent and the resulted solution is applied, and the like can be used.

As the plastic material having a coefficient of linear expansion by heat of 20 ppm or less, particularly, a polyimide and a liquid crystal polymer can be preferably used. Details such as properties and the like of these plastic materials are described in "Plastic Data Book" (Asahi Kasei Amidas Corporation., "Plastic" editorial division, edit), and the like. When a polyimide and the like are used as an insulation layer, it is preferable that a sheet made of a polyimide and the like and an aluminum foil are laminated. The thickness of a sheet made of a polyimide is preferably from 10 µm to 200 µm. When the thickness of a sheet made of a polyimide is smaller than 10 µm, handling in lamination becomes difficult. When the thickness of a sheet made of a polyimide and the like is larger than 200 µm, flexibility disappears, and handling becomes inconvenient. The insulation layer may be provided only on one surface of a metal foil, or may be provided on both surfaces of a metal foil. When provided on both surfaces, the both surfaces may be made of a metal oxide and/or metal nitride, or, the both surfaces may be a plastic insulation layer such as a polyimide insulation layer. Further, it may also be permissible that one surface is an insulation layer made of a metal oxide and/or metal nitride, and other surface is a polyimide sheet insulation layer. If necessary, a hard coat layer and under coat layer may also be provided.

A wet permeation preventing layer (gas barrier layer) may also be provided on the electrode side surface, surface opposite to an electrode, or both of them. As the material constituting the wet permeation preventing layer, inorganic substances such as silicon nitride, silicon oxide and the like are preferably used. The wet permeation preventing layer can be formed by a high frequency sputtering method and the like. On the substrate supporting body, a hard coat layer and under coat layer may also be provided, if necessary.

Furthermore, a substrate provided with an insulation layer on one or both of surfaces of a metal foil is preferable. The metal foil is not particularly restricted, and metal foils such as an aluminum foil, copper coil, stainless foil, gold foil, silver foil and the like can be used. Among others, from the standpoints of easiness in processing and cost, an aluminum foil or copper foil is preferable. The insulation layer is not particularly restricted, and can be formed of, for example, an inorganic substance such as inorganic oxides, inorganic nitrides and the like, a polyester such as polyethylene terephthalate, polybutylene phthalate, polyethylene naphthalate and the like, a plastic such as polystyrene, polycarbonate, polyether sulfone, polyarylate, allyl diglycol carbonate, polyimide, polycycloolefin, norbornene resin, poly(chlorotrifluoroethylene), polyimide and the like.

The moisture permeability of the substrate supporting body is preferably 0.1 g/m²·day or less, and more preferably 0.05 g/m²·day or less, particularly preferably 0.01 g/m²·day or less. The oxygen permeability is preferably 0.1 ml/m²·day/atm or less, more preferably 0.05 ml/m²·day/atm or less, particularly preferably 0.01 ml/m²·day/atm or less. The moisture permeability can be measured by a method according to JIS K7129B method (mainly, MOCON method). The oxygen permeability can be measured by a method according to JIS K7126B method (mainly, MOCON method). By such limitation, invasion of moisture and oxygen into a light emitting element, causing deterioration of durability can be prevented.

### (3) Electrode (cathode or anode)

Any of a transparent conductive layer and backface electrode can be used as a cathode or an anode, and this selection is determined depending on the composition constituting an organic thin film element. Usually, the anode may only have a function as a cathode of supplying a hole to an organic thin film layer, and its form, structure, size and the like are not particularly restricted, and the anode can be appropriately selected from known electrodes depending on the object and application of a light emitting element.

As the material forming the cathode, metal single bodies, alloys, metal oxides, electric conductive compounds, mixtures thereof, and the like can be used, and preferably, materials having a work function of 4.5 eV or less are used. Specific examples thereof include alkali metals (for example, Li, Na, K. Cs and the like), alkaline earth metals (for example, Mg, Ca and the like), gold, silver, lead, aluminum, sodium-potassium alloy, lithium-aluminum alloy, magnesium-silver alloy, indium, rare earth metals (ytterbium and the like), and the like. These may be used singly, and from the standpoint of simultaneous satisfaction of stability and electron injectability, it is preferable to use two or more of them in combination.

Of them, alkali metals and alkaline earth metals are preferable from the standpoint of electron injectability, and materials mainly composed of aluminum are preferable from the standpoint of storage stability. Herein, the materials mainly composed of aluminum include not only aluminum alone, but also alloys of aluminum with an alkali metal or alkaline earth metal in an amount of 0.01 wt% to 10 wt% (for example, lithium-aluminum alloy, magnesium-aluminum alloy and the like) or mixtures thereof.

When light is derived from the cathode side, it is necessary to use a transparent cathode. The transparent cathode may advantageously be substantially transparent to light. For simultaneous satisfaction of electron injectability and transparency, a two-layer structure composed of a thin film metal layer and a transparent conductive layer can also be used. The material of the thin film metal layer is described in detail in JP-A Nos. 2-15595 and 5-121172. The thickness of the above-mentioned thin film metal layer is preferably from 1 nm to 50 nm. When less than 1 nm, it is difficult to produce a thin film layer uniformly. When thicker than 50 nm, transparency to light deteriorates.

The material used in the transparent conductive layer is not particularly restricted as long as it is a transparent material having conductivity or semi-conductivity, and the above-mentioned materials used in an anode can be preferably used. Listed as the preferable material are tin oxide doped with antimony, fluorine and the like (ATO, FTO, etc.), tin oxide, zinc oxide, indium oxide, indium tin oxide (ITO), indium zinc oxide (IZO), and the like. The thickness of the transparent conductive layer is preferably from 30 nm to 500 nm. When the thickness of the transparent conductive layer is smaller than 30 nm, conductivity or semi-conductivity is poor, and when larger than 500 nm, productivity is poor.

The method of forming a cathode is not particularly restricted, and known methods can be adopted, and it is preferable to conduct the formation in a vacuum apparatus. For example, this formation method is appropriately selected from physical methods such as a vacuum vapor deposition method, sputtering method, ion plating method and the like and chemical methods such as CVD, plasma CVD and the like, in view of compatibility with the material in cathode. For example, when metals and the like are selected as the material of a cathode, one or more kinds of metals can be treated simultaneously or sequentially by sputtering and the like. When an organic conductive material is used, a wet film formation method may also be used.

Patterning of a cathode can be conducted by chemical etching by photolithography and the like, physical etching using laser and the like, a vacuum vapor deposition method using a mask, a sputtering method, or a liftoff method, a printing method and the like.

A dielectric layer having a thickness of 0.1 nm to 5 nm made of a fluoride of an alkali metal or alkaline earth metal may be inserted between a cathode and an organic thin film layer. The dielectric layer can be formed, for example, by a vacuum vapor deposition method, sputtering method, ion plating method and the like.

### (4) Patterning

In this case, a multi-color patterning method of the present embodiment is applied. Namely, a pattern corresponding to a plurality of colors is formed by the following processes. Details thereof are shown in examples described later.
i) On a temporary supporting body, three kinds of single color films applied at uniform film thickness are produced corresponding to RGB.
ii) An applied surface of one kind of single color film is overlapped on a sheet to be subjected to patterning.
iii) Pressing is effected by a pressing member having a convex portion of given pattern formed from the rear side of a single color film, to transfer only pattern parts corresponding to the convex portion to a sheet.
iv) Further, for another single color film, pattern parts are transferred to a sheet in the same manner as in the process iii).
   Here, in this procedure, the position of the pattern transferred in the process iii) is read and given positioning is conducted before the transfer.
v) Transfer for a third color is conducted in the same manner as in the process iv).

By this, a patterned organic thin film layer carrying a plurality of organic thin film layers formed having different compositions can be produced.

### (5) Other layers

As the layer constituting an organic thin film element, a protective layer and a sealing layer are preferably provided for preventing deterioration in a light emitting ability. Further, in a transfer material, a releasing layer may be provided between a temporary supporting body and an organic thin film layer and an adhesive layer may be provided between an organic thin film layer and a film forming surface for improving transferability as long as a light emitting ability is not affected.

### (a) Protective layer

The organic thin film element may have a protective layer described in JP-A Nos. 7-85974, 7-192866, 8-22891, 10-275682, 10-106746 and the like. The protective layer is formed on the uppermost surface of an organic thin film element. Here, the uppermost surface indicates the outer side surface of a backface electrode when a substrate supporting body, transparent conductive layer, organic thin film layer and backface electrode are laminated in this order, for example, and indicates the outer side surface of a transparent conductive layer when a substrate supporting body, backface electrode, organic thin film layer and transparent conductive layer are laminated in this order. The form, size, thickness and the like of the protective layer are not particularly restricted, The material constituting the protective layer is not particularly restricted as long as it has a function to suppress invasion or permeation of substances deteriorating an organic thin film element such as moisture, oxygen and the like into an element, and for example, silicon monoxide, silicon dioxide, germanium monoxide, germanium dioxide and the like can be used.

The method of forming the protective layer is not particularly restricted, and for example, a vacuum vapor deposition method, sputtering method, reactive sputtering method, molecule beam epitaxy method, cluster ion beam method, ion plating method, plasma polymerization method, plasma CVD method, laser CVD method, thermal CVD method, coating method and the like can be applied.

### (b) Sealing layer

It is preferable to provide a sealing layer for preventing invasion of moisture and oxygen, on an organic thin film element. As the material forming the sealing layer, copolymers of tetrafluoroethylene and at least one comonomer, fluorine-containing copolymers having a cyclic structure in the copolymerization main chain, copolymers of polyethylene, polypropylene, polymethyl methacrylate, polyimide, polyurea, polytetrafluoroethylene, polychlorotrifluoroethylene, polydichlorodifluoroethylene, chlorotrifluoroethylene or dichlorodifluoroethylene with other comonomers, water-absorbing substances having a water absorption coefficient of 1% or more, moisture proof substances having a water absorption coefficient of 1% or less, metals (In, Sn, Pb, Au, Cu, Ag, Al, Ti, Ni and the like), metal oxides (MgO, SiO, SiO₂, Al₂O₃, GeO, NiO, CaO, BaO, Fe₂O₃, Y₂O₃, TiO₂ and the like), metal fluorides (MgF₂, LiF, AlF₃, CaF₂ and the like), liquid carbon fluorides (perfluoroalkanes, perfluoroamines, perfluoro ethers and the like), those obtained by dispersing an absorbing agent for moisture and oxygen in a liquid carbon fluoride, and the like can be used.

For the purpose of blocking moisture and oxygen from outside, an organic thin film layer is preferably sealed with a sealing members such as a sealing plate, sealing vessel and the like. A sealing member may be provided only at the backface electrode side, or the whole light emitting laminate may be coated with a sealing member. The form, size, thickness and the like of the sealing member are not particularly restricted as long as it can seal an organic thin film layer and can block air from outside. As the material used in the sealing member, glass, stainless steel, metals (aluminum, and the like), plastics (polychlorotrifluoroethylene, polyesters, polycarbonates, and the like), ceramics and the like can be used.

In providing a sealing member on a light emitting laminate, a sealing agent (adhesive) may be appropriately used. When the whole light emitting laminate is coated with a sealing member, sealing members may be mutually thermally fused without using a sealing agent. As the sealing agent, an ultraviolet-hardening resin, thremosetting resin, two pack type hardening resin and the like can be used.

Further, a moisture absorbent or inert liquid may be inserted in a space between a sealing container and an organic thin film element. The moisture absorbent is not particularly restricted, and specific examples thereof include barium oxide, sodium oxide, potassium oxide, calcium oxide, sodium sulfate, calcium sulfate, magnesium sulfate, phosphorus pentoxide, calcium chloride, magnesium chloride, copper chloride, cesium fluoride, niobium fluoride, calcium bromide, vanadium bromide, molecular sieve, zeolite, magnesium oxide and the like. As the inert liquid, paraffins, liquid paraffins, fluorine-based solvents (perfluoroalkanes, perfluoroamines, perfluoro ethers and the like), chlorine-based solvents, silicone oils and the like can be used.

The light emitting element in the present embodiment can be allowed to emit light by applying direct voltage (alternating current component may be contained, if necessary) (usually from 2 V to 4 V) or direct current between a cathode and an anode. For driving the light emitting element, methods described in JP-A Nos. 2-148687, 6-301355, 5-29080, 7-134558, 8-234685 and 8-241047, US Patent Nos. 5828429 and 6023308, Japanese Patent No. 2784615, and the like can be utilized.

### EXAMPLES

Regarding embodiments of the present invention, only contents described in the above-mentioned "patterning" column will be described below.

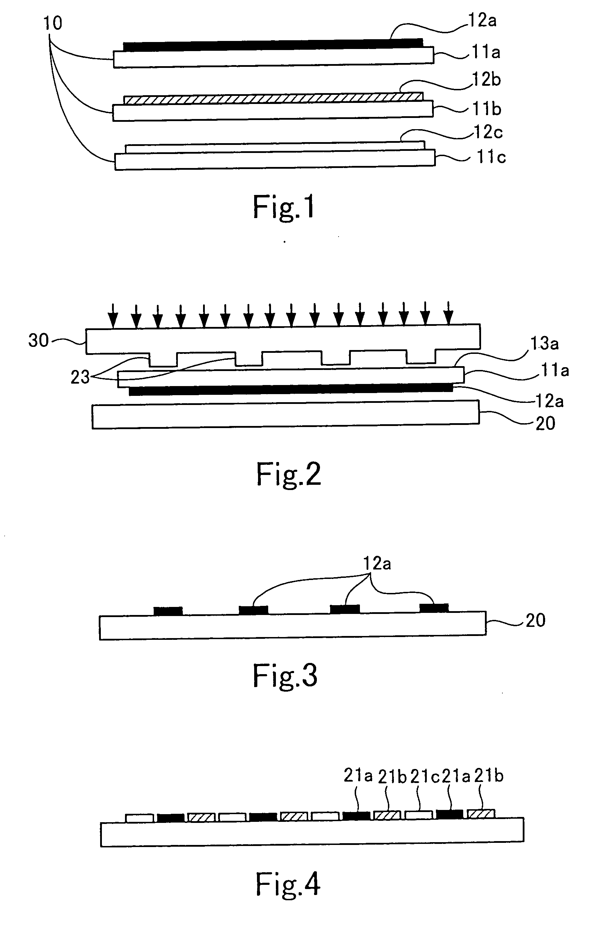

Figs 1 to 4 are process views showing a method of producing a multi-color pattern member which is one embodiment of the method of producing a pattern member of the present invention.

Fig. 1 shows three kinds of single color films 11a, 11b and 11c produced by a single color film production process. In the single color film production process of the present embodiment, three inks of RGB (light emitting materials) are applied on a film 10, and dried, to produce three kinds of single color films 11a, 11b and 11c carrying RGB three color ink layers 12a, 12b and 12c respectively formed on the surface. These are sheets called temporary supporting body in the above-mentioned description. Details of the method of applying them will be described later.

Then, the transfer process will be explained.

Figs. 2 to 3 show a transfer process. In this transfer process, a single color film of one color among the above-mentioned three kinds of single color films 11a, 11b and 11c, for example, a single color film 11a of R color, is overlapped on a sheet 20 such that a color ink layer 12a of the single color film 11a comes in contact with the sheet 20, and the overlapped sheet 20 and single color film 11a are pressed by a pressing member 30 having a convex portion 23 of given pattern formed on its surface, from the rear surface 13a against the surface on which the color ink layer 12a of the single color film 11a is formed, to transfer parts corresponding to the pattern of the convex portion 23 of the color ink layer 12a to the sheet 20, and this operation is repeated for RGB three colors, to produce a multi-color pattern sheet 21 carrying patterns 21a, 21b and 21c made of three color ink layers of RGB of given pattern formed on the sheet 20, as shown in Fig. 4. This multi-color pattern sheet 21 is one example of the pattern member referred in the present invention.

The sheet 20 is one example of the substrate referred in the present invention, and as the sheet 20, materials such as resins, metals, glass and the like can be used.

As the transfer mode, a transfer mode using pressing means and heating means together is preferable.

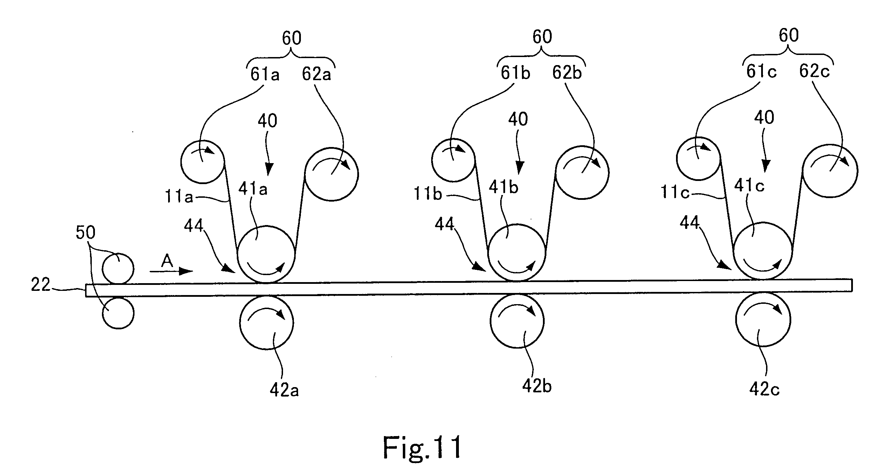

As the pressing member 30, a multi-color pattern sheet can also be produced according to batch mode by using a flat plate and the like, however, it is preferable to produce a multi-color pattern sheet by using, as the pressing member 30, transfer means composed of a patterning roll having a convex portion of given pattern formed on its surface and a counter roll as in a multi-color pattern sheet production apparatus shown in Fig. 11, as a continuous process, for example.

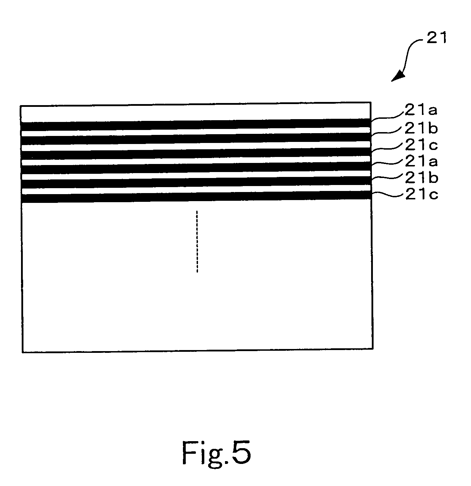

Fig. 5 is a view showing a pattern in the form of stripe of the multi-color pattern sheet of the present embodiment.

As shown in Fig. 5, on this multi-color pattern sheet 21, patterns 21a, 21b and 21c in the form of stripe of RGB three colors are formed.

In Fig. 5, an example of a multi-color pattern sheet having patterns formed in the form of stripe is exemplified, however, patterns in the form of matrix may also be formed instead of these pattern in the form of stripe.

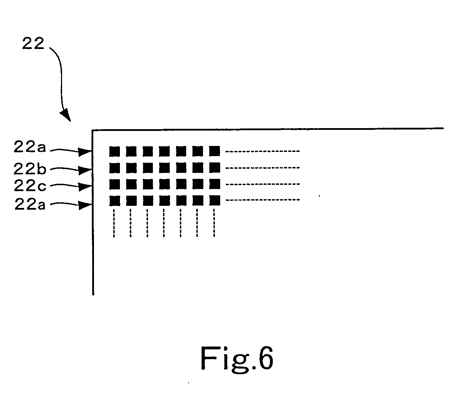

Fig. 6 is a view showing patterns in the form of matrix of the multi-color pattern sheet of the present embodiment.

As shown in Fig. 6, on this multi-color pattern sheet 21, patterns 22a, 22b and 22c in the form of matrix of RGB three colors are formed. For producing the multi-color pattern sheet having the patterns in the form of matrix, it may be permissible that a convex portion 23 in the form of matrix is formed on the surface of the pressing member 30 shown in Fig. 2, and a transfer process is conducted using this pressing member.

Next, the application method in the present embodiment will be explained.

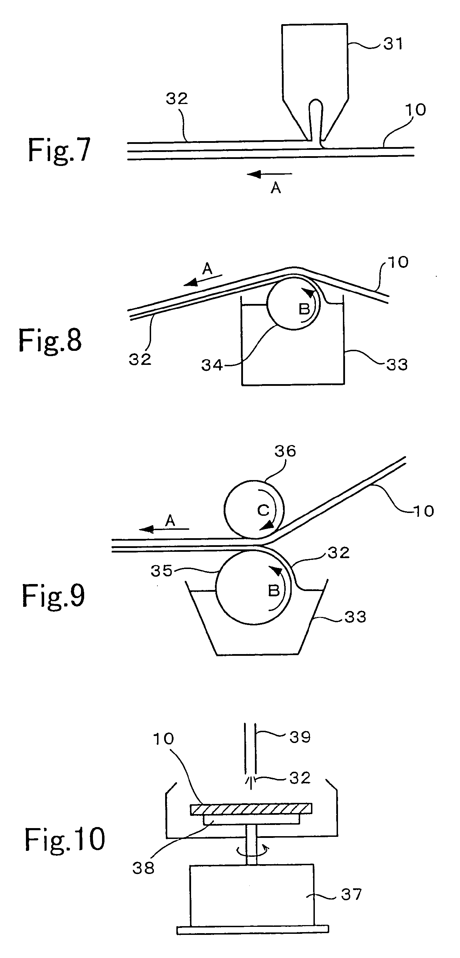

Figs. 7 to 10 are schematic views according to various application modes that can be adopted in the present embodiment.

Fig. 7 shows an application method of die coater mode, and ink accommodated in a die 31 is supplied on a substrate 10 which is carried toward the direction of an arrow A and ink 32 is applied on the substrate 10.

Fig. 8 shows an application method of bar coater mode, and ink 32 is applied on a substrate 10 carried toward the direction of an arrow A, by a bar 34 rotating along the direction of an arrow B partially immersed in ink in an ink bath 33.

Fig. 9 shows an application method of gravure coater mode, and ink 32 is applied on a substrate 10 carried toward the direction of an arrow A, by an application roll 35 immersed in ink in an ink bath 33 and rotating along the direction of an arrow B and a pressing roll 36 rotating along the direction of an arrow C facing the application roll 35.

Fig. 10 shows an application method of spin coater mode, and ink 32 is dropped from a nozzle 39 on a substrate 10 placed on a rotating table 38 rotation-driven by a motor 37, and the dropped ink spreads on the surface of the substrate 10 by centrifugal force, to cause ink application on the surface of the substrate 10.

Next, the multi-color pattern sheet production apparatus of the present invention will be described.

Fig. 11 is a schematic constitutional view showing a multi-color pattern sheet production apparatus which is one embodiment of the pattern member production apparatus of the present invention.

As shown in Fig. 11, with this multi-color pattern sheet production apparatus, three kinds of single color films 11a, 11b and 11c (see Fig. 1) having color ink layers 12a, 12b and 12c of RGB formed on the surface are sequentially overlapped on a transparent glass substrate 22, and the color ink layers 12a, 12b and 12c on these single color films 11a, 11b and 11c are sequentially transferred to the transparent glass substrate 22, and this operation is repeated for three colors, to produced a multi-color pattern sheet (one example of the pattern member referred in the present invention) having multi-color patterns by three color inks formed on the surface.

Namely, this multi-color pattern sheet production apparatus comprises transfer means 40 for three colors of transferring the above-mentioned color ink layer of the single color film to the transparent glass substrate 22, being composed of patterning rolls 41a, 41b and 41c having a convex portion in the form of stripe formed in the surface, and counter rolls 42a, 42b and 42c placed facing the patterning rolls 41a, 41b and 41c and sandwiching both the transparent glass substrate 22 and any one of the above-mentioned single color films 11a, 11b and 11c, sheet supplying means 50 for supplying the transparent glass substrate 22 to the transfer means 40 for R color, and single color film supplying means 60 for three colors of supplying one single color film of three single color films 11a, 11b and 11c to between the patterning rolls 41a, 41b and 41c and the transparent glass substrate 22 supplied to a nip portion 44 sandwiched by the patterning rolls 41a, 41b and 41c and the counter rolls 42a, 42b and 42c, so that the color ink layer of this single color film is overlapped so as to contact with the transparent glass substrate 22.

The single color film supplying means 60 for three colors are composed of a feeding rolls 61a, 61b and 61c and winding rolls 62a, 62b and 62c.

The transparent glass substrate 22 in the present embodiment corresponds to the substrate referred in the present invention, and the substrate is not limited to glass and various resins and the like can be used.

Examples of producing a multi-color pattern sheet by this multi-color pattern sheet production apparatus will be illustrated below.

Previously, into three kinds of RGB pigments are mixed and dispersed a binder, alcohol and application aid, respectively, to produce three RGB inks. These three RGB inks are applied at a width of 1 m and an application speed of 20 m/min on the surface of a PET (polyethylene terephthalate) film having a thickness of 20µ by a die coater shown in Fig. 7 and dried, to produced three kinds of single color films 11a, 11b and 11c (see Fig. 1) having color ink layers 12a, 12b and 12c of RGB three colors formed on the surface . The application thickness of each color ink is about 20µ in wet condition and about 0.1µ in dry condition.

Next, these single color films 11a, 11b and 11c are installed on the single color film supplying means 60, respectively, composed of the feeding rolls 61a, 61b and 61c and the winding rolls 62a, 62b and 62c of the multi-color pattern sheet production apparatus shown in Fig. 11.

Next, the transparent glass substrate 22 is carried toward the direction of an arrow A by the sheet supplying means 50, and supplied to the nip portion 44 sandwiched by the patterning roll 41a for R color and the counter roll 42b. To this nip portion 44, the single color film 11a of R color supplied from the feeding roll 61a and wound by the winding roll 62a is supplied in overlap such that the color ink layer 12a comes in contact with the transparent glass substrate 22, and parts corresponding to the pattern of the convex portion 23 of the color ink layer 12a are transferred to the transparent glass substrate 22 by the patterning roll 41a having a convex portion of stripe pattern formed on the surface. In this operation, the temperature of each patterning roll is 150°C, the transfer pressure is 5 kg/cm², and the feeding speed of each single color film is 2 m/min.

Thus, a pattern in the form of stripe having a width of 200µ and an interval of 550µ is formed on the transparent glass substrate 22. The above-mentioned transfer is conducted for three RGB single color films, to produce a multi-color pattern sheet continuously.

Next, the patterning roll used in this multi-color pattern sheet production apparatus will be described.

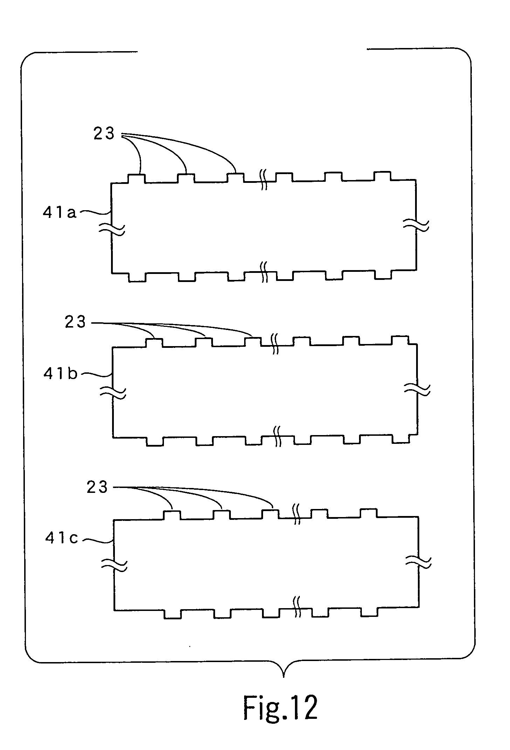

Fig. 12 is a sectional view along the rotation axis direction of the patterning roll in the present embodiment.

As shown in Fig. 12, on the surface of the patterning rolls 41a, 41b and 41c (see Fig. 11), the convex portion 23 of stripe pattern is formed along the peripheral direction, the positions of the convex portion 23 along the roll width direction of the patterning rolls mutually differ, and stripes of respective colors are formed at respectively different positions along the rotation axis direction of the glass substrate 22 (see Fig. 11).

The diameter of each patterning roll is 200 mm, and patterning is so conducted that the width of the convex portion 23 along the roll rotation axis direction is 200 µ, and the width along the roll rotation axis direction of concave portions other than the convex portion 23 is 550 µ.

Each patterning roll contains inside a heat source, and heating is effected by this heat source and the single color film and the transparent glass substrate are pressed by this patterning roll and a counter roll situated facing this, to effect transfer of a color ink layer from the single color films 11a, 11b and 11c to the transparent glass substrate 22.

The pattern of the convex portion formed on the patterning roll is not limited to the pattern in the form of stripe shown in Fig. 12, and the pattern in the form of matrix as shown in Fig. 6 may also be adopted.

Other examples will be described below.

The three RGB inks were changed as shown below, and three single color films 11a, 11b and 11c (see Fig. 1) having color ink layers 12a, 12b and 12c of RGB three colors formed on the surface of a PET (polyethylene terephthalate) film having a thickness of 6µ were produced by a die coater shown in Fig. 7. The application thickness of each color ink was controlled such that it was about 0.05µ under dried condition. · RGB ink composition:
Compounds selected from the structural formula [chemical formula 1]: 1 part by weight
Structural formula [chemical formula 2] (average molecular weight: 17000): 40 parts by weight
Dichloroethane: 3200 parts by weight 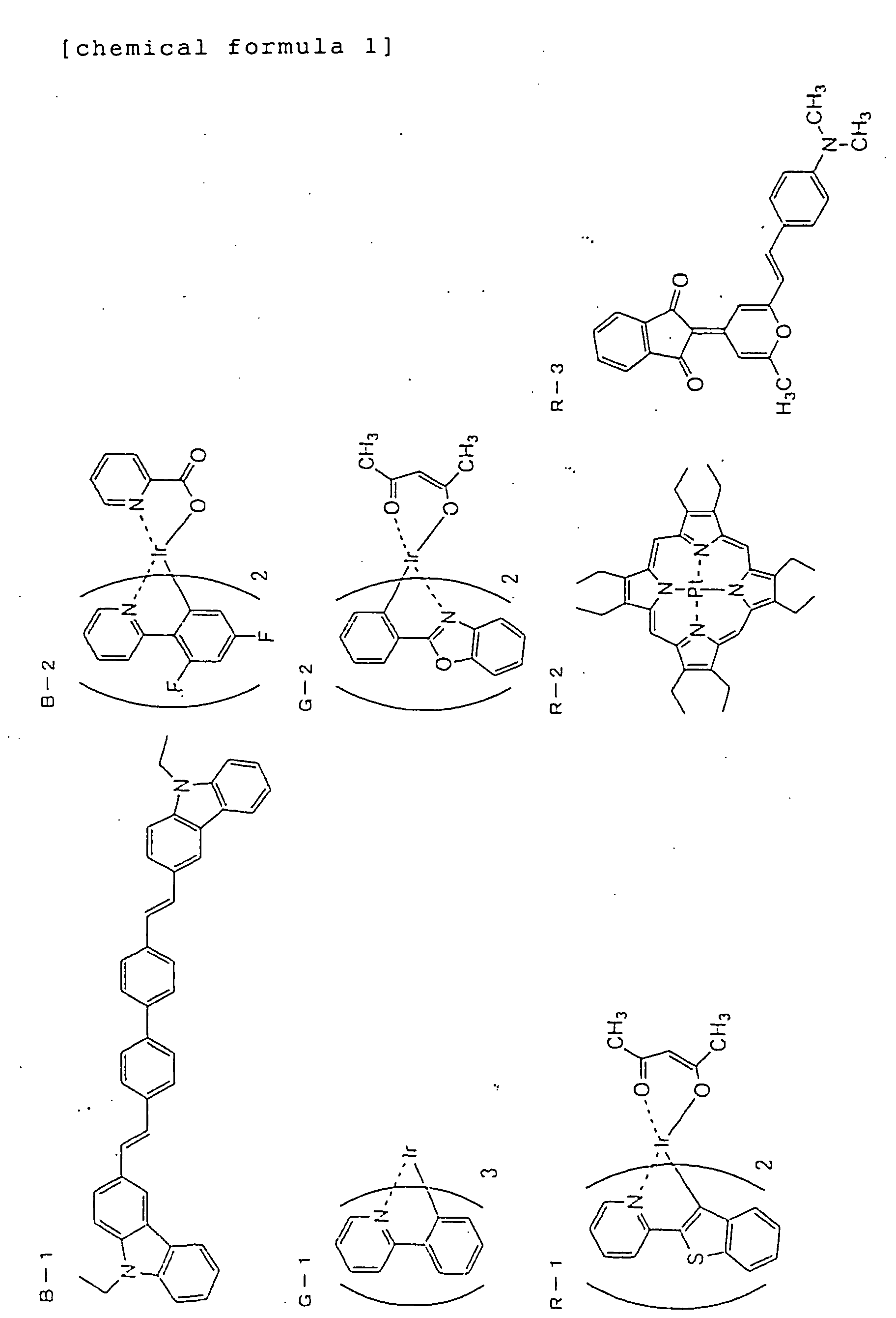 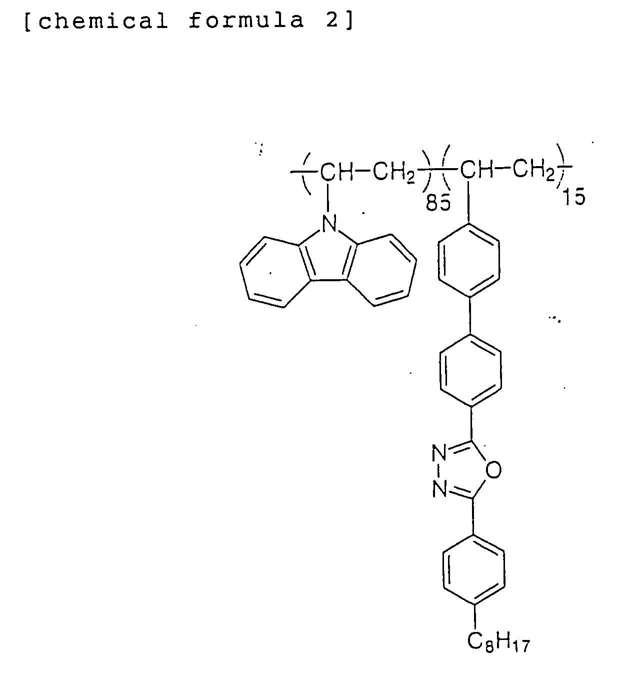
Regarding the compounds selected from [chemical formula 1], B was selected from B-1 and B-2, G was selected from G-1 and G-2, R was selected from R-1, R-2 and R-3, and each two kinds of single color films for B and G and three kinds of single color films for R were produced.

Though the substrate A described below was used instead of the transparent glass substrate 22, a multi-color pattern was created likewise.

### ·Production of substrate A

A polyimide film (UPILEX-50S, manufactured by UBE INDUSTRIES, LTD.) having a thickness of 50 µm was charged in a washing vessel, and washed with isopropyl alcohol (IPA), then, oxygen plasma treatment was conducted. On one surface of a glass plate on which oxygen plasma treatment had been conducted, Al was deposited in a press-reduced atmosphere of about 0.1 mPa, to form an electrode having a film thickness of 0.3 µm. Further, LiF was deposited in the same pattern as for the Al layer, as a dielectric layer, to obtain a film thickness of 3 nm. An aluminum lead line was connected from the Al electrode, to form a laminated structure. Next, in a pressure-reduce atmosphere of about 0.1 mPa, an electron transporting compound having the following structural formula [chemical formula 3] was deposited, to form an electron transporting organic thin film layer having a thickness of 9 nm on LiF.

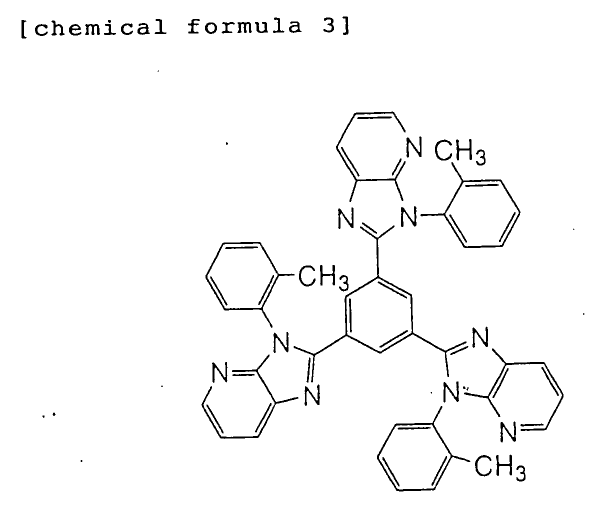

Then, the following transparent substrate B or C and the substrate A were overlapped such that the electrodes faced sandwiching a light emitting organic thin film layer, and they were heated under press and pasted using a couple of heat rollers at 160°C, 0.3 MPa and 0.05 m/min, to obtain excellent RGB pattern color development.

### · Production of transparent substrate B

Using a glass plate having a thickness of 0.5 mm, and this substrate supporting body was introduced into a vacuum chamber, and using an ITO target having a SnO₂ content of 10 wt% (indium:tin = 95:5 (molar ratio)), a transparent electrode composed of an ITO thin film having a thickness of 0.2 µm was formed by DC magnetron sputtering (condition: temperature of substrate supporting body: 250° C, oxygen pressure: 1×10⁻³ Pa). The surface resistance of the ITO thin film was 10 Ω/□ . An aluminum lead line was connected from the transparent electrode (ITO), to form a laminated structure. The glass plate having the transparent electrode formed thereon was placed in a washing vessel, and washed with isopropyl alcohol (IPA), then, oxygen plasma treatment was conducted. On the surface of the treated transparent electrode, an application solution of the following composition was applied by a die coater shown in Fig. 7, and dried at room temperature, to form a hole transporting organic thin film layer having a thickness of 100 nm.

Hole transporting compound (PTPDES) of the structural formula [chemical formula 4]: 40 parts by weight
Additive (TBPA) of the structural formula [chemical formula 5]: 10 parts by weight
Dichloroethane: 3200 parts

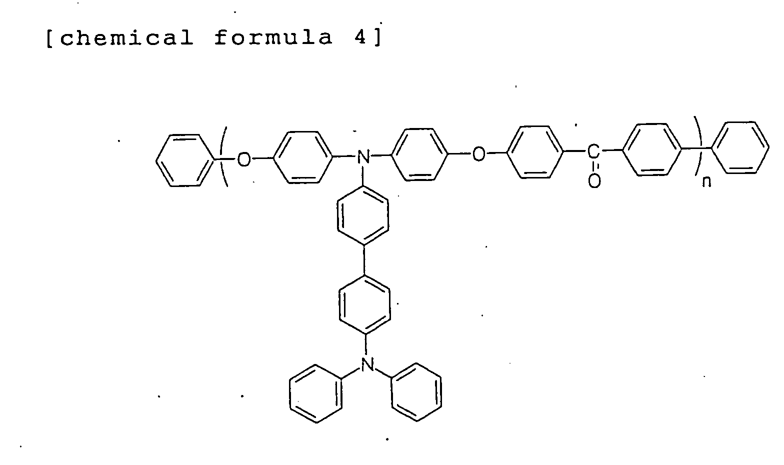

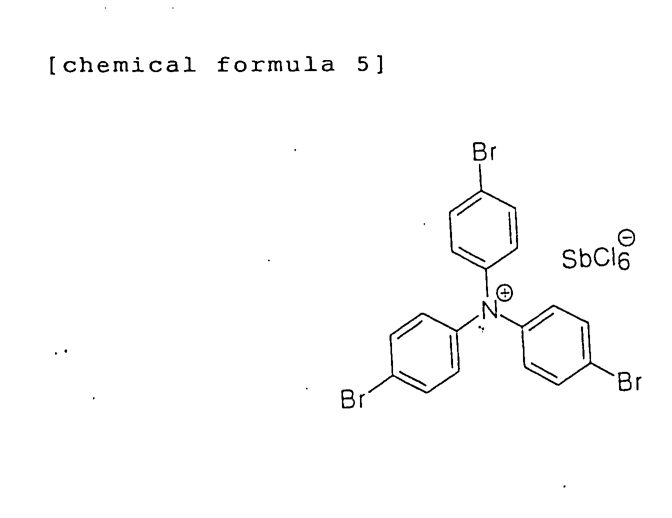

### · Production of substrate C

Production was conducted in the same manner as for the substrate B except that the solution for producing a hole transporting organic thin film layer was changed to an aqueous dispersion of polyethylene dioxythiophen polystyrenesulfonic acid (manufactured by BAYER, Baytron P: solid content: 1.3 wt%) and drying was conducted at 150° C for 2 hours in vacuo.

The results of BGR pattern light emission are summarized in the following table.

The uniformity of patterning was observed by a microscope of × 100, and evaluated as × when deletion is observed, and as ○ when deletion is not observed and uniformity is excellent.

In light emission, the light emitting voltage, that is the driving voltage when 100 cd/m², was shown in the following table. As a result, it was confirmed that light emission occurred uniformly by patterning according to the present invention.

**[Table 1]**

| Selected compound [Chemical formula 1] | | | Patterning uniformity | Light emitting voltage (V) | | | Light emitting uniformity |
|---|---|---|---|---|---|---|---|
| Blue color | Green color | Red color | | B | G | R | |
| B-2 | G-1 | R-1 | ○ | 12 | 12 | 16 | ○ |
| B-1 | G-1 | R-1 | ○ | 14 | 12 | 16 | ○ |
| B-1 | G-1 | R-3 | ○ | 14 | 12 | 18 | ○ |
| B-2 | G-2 | R-1 | ○ | 12 | 12 | 16 | ○ |
| B-2 | G-2 | R-2 | ○ | 12 | 12 | 16 | ○ |

As describe above, according to the production method described above, a pattern member is produced by a single color film production process of producing single color films of a plurality of colors having a color ink layer formed on the surface, and a transfer process in which a single color film of one color among the above-mentioned single color films of a plurality of colors is overlapped on a substrate, and pressed by a pressing member having a convex portion of given pattern formed on the surface to transfer the color ink layer to the substrate, and this operation is repeated at frequency corresponding to a plurality of colors for forming a multi-color pattern on the subtrate, therefore, a pattern member can be produced with a small number of processes at low cost.

A pattern member having a color ink layer of uniform thickness can be produced without influenced by the physical properties of coloring inks and recipe thereof.

Further, according to the above-mentioned production apparatus, the equipment cost is low and an apparatus of producing a pattern member showing high productivity can be realized since the apparatus comprises transfer means for a plurality of colors composed of a patterning roll having a convex portion of given pattern formed on the surface and a counter roll placed facing the patterning roll, substrate supplying means of supplying a substrate to transfer means for a plurality of colors sequentially, and single color film supplying means for a plurality of colors of supplying a single color film of one color to between a patterning roll and a substrate supplied to a nip portion sandwiched by a patterning roll and a counter roll such that the single color film is overlapped to the substrate.

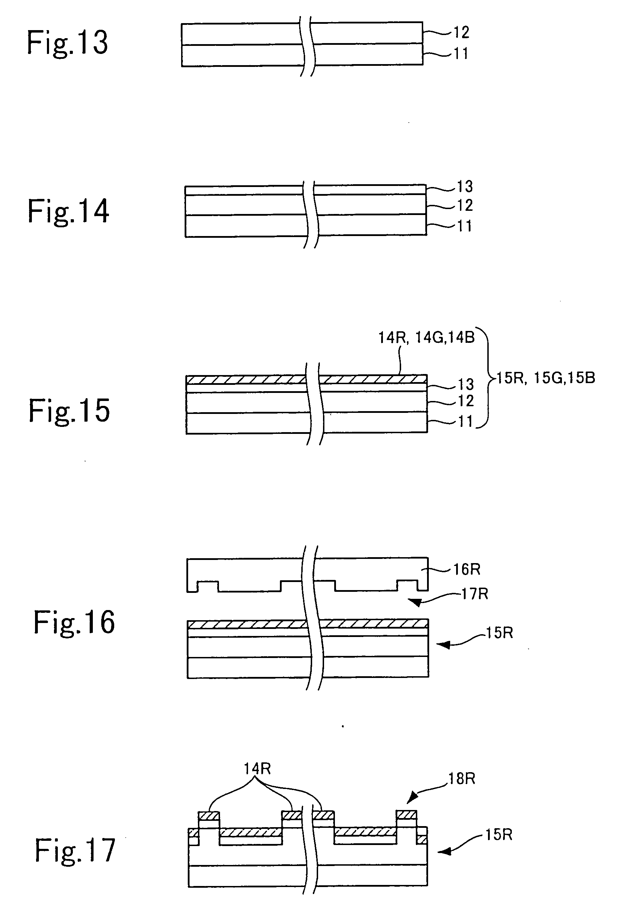

Figs. 13 to 16 are schematic process views showing the first embodiment of the second method of producing a pattern member of the present invention.

### [First Embodiment]

Three transfer substrates 11 having a thickness of 50 µm as shown in Fig. 13 were prepared, and a plastic deformation layer 12 is applied on each of the transfer substrates 11. As the transfer material 11, PET (polyethylene terephthalate), PP (polypropylene), TAC (triacetylcellulose) and the like can be used.

As the plastic deformation layer 12, layers made of a polymer such as a methacrylic acid copolymer, crotonic acid copolymer, maleic acid copolymer, itaconic acid copolymer, partially esterified maleic acid copolymer, polyvinylpyrrolidone, polyethylene oxide, polyvinyl alcohol, gelatin and the like are listed. Commercially available photo resists may also be used. For improving film strength, those prepared by adding an alcohol-soluble nylon or epoxy resin to them may also be used.

Next, a releasing layer 13 is formed as shown in Fig. 14 on the plastic deformation layer 12 of these three transfer substrates 11.

As the releasing layer 13, substances obtained by adding wax such as paraffin wax, montan-based wax, bisamide-based wax and the like, silicone resins, fluorine-based compound and the like to the polymer used in the plastic deformation layer 12 are used. Main polymers in the releasing layer 13 and the plastic deformation layer 12 may be the same or different.

Next, as shown in Fig. 15, by applying an R ink on the releasing layer 13 on one transfer material 11 of three transfer materials 11 carrying the releasing layer formed and drying the ink, a coloring material layer 14R emitting light of Red color is formed at a thickness of 50 nm when current flows, and a coloring transfer material 15R of R color is formed (single color transfer material forming process).

Further, by applying a G ink on the releasing layer 13 on another transfer material 11 and drying the ink, a coloring material layer 14G emitting light of Green color is formed at a thickness of 50 nm when current flows, and a coloring transfer material 15G of G color is formed (single color transfer material forming process).

Furthermore, by applying a B ink on the releasing layer 13 on another transfer material 11 and drying the ink, a coloring material layer 14B emitting light of Blue color is formed at a thickness of 50 nm when current flows, and a coloring transfer material 15B of B color is formed (single color transfer material forming process).

Next, as shown in Fig. 16, by pressing the surface of the coloring transfer material 15R of R color by a hot press apparatus equipped with a mold 16R (pressing member) on which a concave portion having a longitudinal length of 200 µm, a transverse length of 50 µm and a height of 30 µm is arranged regularly in given pattern on the surface at a temperature of 160° C and a pressure of 800 kg/cm² for 5 minutes, the coloring material layer 14R projects by 30 µm on the surface of the coloring transfer material 15R of R color as shown in Fig. 17 and an irregular pattern 17R having a depth of 30 µm corresponding to the irregular pattern 17R of the pressing member (see Fig. 16) is formed.

Further, pressing is conducted by the pressing member under the same conditions also for the coloring transfer material 15G of G color and the coloring transfer material 15B of B color, to form given irregular patterns respectively on the surfaces of the transfer materials (pattern formation process).

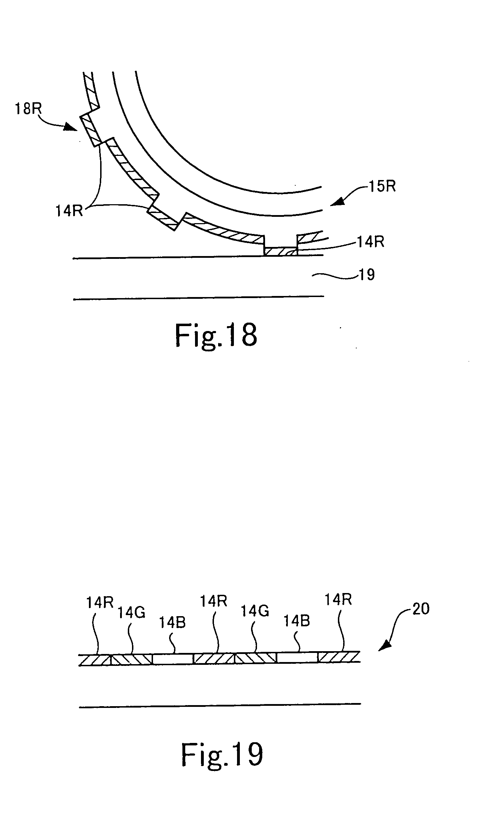

Next, as shown in Fig. 18, the coloring transfer material 15R of R color having the irregular pattern 18R formed is overlapped on a separately prepared glass substrate 19 having a thickness of 50 µm and allowed to proceed continuously at a speed of 0.05 m/min while being pressed by a rubber roller at a temperature of 160°C and a pressure of 3 kg/cm², to transfer the coloring material layer 14R on the coloring transfer material 15R of R color to the glass substrate 19. Next, the coloring transfer material 15G of G color is overlapped on the glass substrate 19 such that the coloring material layer 14G on the coloring transfer material 15G of G color is transferred to a position adjacent to the coloring material layer 14R on the glass substrate 19, and the coloring material layer 14G is transferred to the glass substrate 19 under the same conditions as for the coloring transfer material 15R of R color. Further, the coloring transfer material 15B of B color is overlapped on the glass substrate 19 such that the coloring material layer 14B on the coloring transfer material 15B of B color is transferred to a position adjacent to the coloring material layer 14G on the glass substrate 19, and the coloring material layer 14B is transferred to the glass substrate 19 under the same conditions as for the coloring transfer material 15R of R color (transfer process).

Thus, as shown in Fig. 19, a pattern member 20 is produced having RGB three color patterns composed of the coloring material layer 14R, coloring material layer 14G and coloring material layer 14B formed on the surface of the glass substrate 19.

In the above-mentioned first embodiment, an example of forming a releasing layer between a plastic deformation layer and a coloring material layer of each color is shown, however, the releasing layer can be omitted when its formation is not necessarily required.

Likewise, the plastic deformation layer can be omitted when its formation is not necessarily required.

In the above-mentioned first embodiment, an example in which formation of a plastic deformation layer, formation of a releasing layer and formation of a coloring layer of each color are conducted separately is shown, however, a plastic deformation layer, releasing layer and a coloring layer of each color may be overlapped and formed simultaneously. In this case, the conditions shown in Figs. 1 and 2 are not present, and the layer structure in Fig. 3 is directly formed.

### [Second Embodiment]

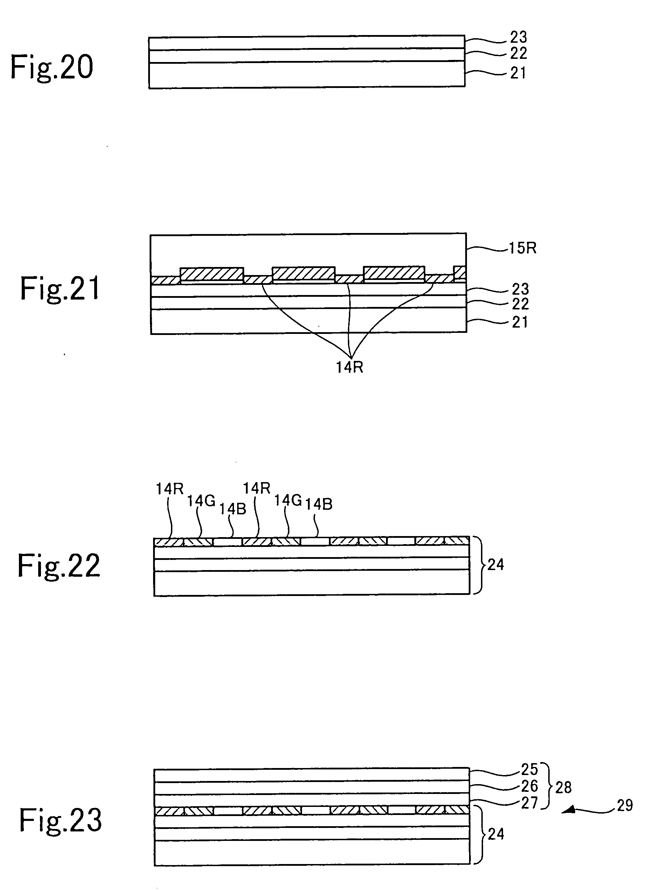

Figs. 20 to 23 are schematic process views showing the second embodiment of the second method of producing a pattern member of the present invention.

As shown in Fig. 20, an aluminum layer was laminated on a polyimide sheet substrate having a thickness of 100 µm to produce an oxygen moisture barrier sheet substrate 21. On the opposite surface to the aluminum layers side of the sheet substrate 21, an Al electrode layer 22 having a thickness of 50 nm is formed by vapor deposition, further, on this, an electron transporting layer 23 is applied to give a thickness of 50 nm.

Next, as shown in Fig. 21, the coloring material layer 14R of the coloring transfer material 15R of R color having the irregular pattern 18R by the pattern formation process shown in Fig. 16 is overlapped on the surface of the electron transporting layer 23 of the sheet substrate 21, and the same transferring process as shown in Fig. 18 is conducted to transfer the coloring material layer 14R to the sheet substrate 21, further, the transferring process with the coloring transfer material 15G of G color and the coloring transfer material 15B of B color is repeated on the sheet substrate 21, to transfer the coloring material layer 14G and the coloring material layer 14B, finally forming an organic EL light emitting layer member 24 of RGB three colors as shown in Fig. 22.

Next, as shown in Fig. 23, this organic EL light emitting layer member 24 is pasted to a member 28 obtained by forming a patterned transparent electrode 26 and hole transporting layer 27 on a transparent substrate 25, to produce an organic EL display material 29.

### [Embodiment 3]

A coloring material layer having a thickness of 2 µm containing a coloring matter of R color which causes not light emission is formed, instead of the coloring material layer 14R emitting light of Red color when current flows in the above-mentioned single color transfer material forming process of the first embodiment (see Fig. 15), on the transfer substrate 11 to form a transfer material of R color, and according to the same manner, a transfer material of G color and a transfer material of B color are formed.

Next, the same pattern formation operation and the same transfer operation to a substrate are conducted as in the pattern formation process and transfer process in the first embodiment, to produce a patterned color filter.

As described above, according to the second method of producing the pattern member of the present invention, treatment can be effected in dry mode, therefore, a material is not invaded by an etching treatment solution and resist removal solution, and a pixel pattern of high precision can be formed.

Since only a coloring material layer of a convex portion is transferred to a substrate in transfer, transfer can be effected infallibly also on the surface of a substrate having irregularity on which ITO and the like have been formed.

Further, since an electron transporting layer, light emitting layer, hole transporting layer and the like can be laminated in dry mode, interlaminar mixing as in application of a plurality of layers and printing does not occur, and a pixel pattern can be formed with high precision and high efficiency.

Also, since leaking from a mask in vapor deposition does not occur, formation of fine pixel is possible, a pattern member of high precision can be formed.

Still further, a single color transfer material formation process, pattern formation process and transfer process can be conducted continuously, a pattern member can be produced at low cost.

According to the pattern member of the present invention, a multi-color pattern member can be obtained at high productivity and low cost.

## Claims

1. A method of producing a pattern member comprising the steps of:
by applying a color ink on each of a plurality of films and drying the color ink, producing a plurality of single color films each having a different color of a plurality of colors and a color ink layer formed on a surface of each single color film; and
transferring a part of a color ink layer to a substrate to produce a pattern member having a multi-color pattern made of color inks of the plurality of colors formed on the substrate by repeating, at frequency corresponding to the number of the plurality of colors, an operation of overlapping one of the plurality of single color films having one color on the substrate such that a color ink layer of the single color film comes in contact with the substrate, and then, pressing the overlapped substrate and single color film by a pressing member having a convex portion of given pattern formed on its surface, to transfer a portion of the color ink layer corresponding to a pattern of the convex portion to the substrate.

2. The method of producing a pattern member according to claim 1 wherein the step of producing a plurality of single color films includes a process of applying an ink of given color on the substrate by any application methods selected from a die coater, bar coater, spin coater and gravure coater.

3. The method of producing a pattern member according to claim 1, wherein the step of transferring a part of a color ink layer to a substrate comprises performing transfer using a pressing member having a convex portion of a pattern in the form of stripe or matrix formed on its surface.

4. An apparatus of producing a pattern member that has a multi-color pattern made of color inks of a plurality of colors on its surface by repeating, at frequency corresponding to the number of the plurality of colors, an operation of overlapping on a given substrate a plurality of single color films each having a different color of the plurality of colors and a color ink layer formed on its surface, to transfer the color ink layer on the single color film to the substrate, the apparatus comprising:
transferring means corresponding to the number of the plurality of colors, transferring the color ink layer of the single color film to the substrate, the transferring means being constituted of a patterning roll having a convex portion of given pattern formed on its surface and a facing roll placed facing the patterning roll so that the patterning roll and facing roll sandwich both the substrate and the single color film between them;
substrate feeding means sequentially feeding the substrate to the transfer corresponding to the number of the plurality of colors; and
single color film feeding means corresponding to the number of the plurality of colors, feeding a single color film of one color among the single color films of the plurality of colors, between the patterning roll and the substrate fed to a nip portion sandwiched by the patterning roll and the facing roll, such that the color ink layer of the single color film overlaps on and comes in contact with the substrate.

5. A method of producing a pattern member comprising the steps of:
forming a plurality of single color transfer materials each having one of a plurality of colors, by forming a coloring material layer of each color on each of a plurality of transfer substrates;
forming a pattern by a process in which each surface of the single color transfer materials of the plurality of colors is pressed by a pressing member having irregularity of given pattern formed on its surface, to form an irregularity pattern corresponding to the irregularity of the pressing member on the surface of the single color transfer material; and
transferring a part of the coloring material layer to the transfer substrate to produce a pattern member having a multi-color pattern of the plurality of colors on the substrate by repeating, at frequency corresponding to the number of the plurality of colors, an operation in which the surface of the single color transfer material of one color among the single color transfer materials of a plurality of colors having an irregularity pattern formed is overlapped on a given substrate and the coloring material layer at the convex portion of the single color transfer material is transferred to the substrate.

6. The method of producing a pattern member according to claim 1, wherein the step of forming a plurality of single color transfer materials is a step in which a plastic deformation layer is formed on the transfer substrate and a coloring material layer is formed simultaneously with the plastic deformation layer, overlapping on the plastic deformation layer.

7. The method of producing a pattern member according to claim 1, wherein the step of forming a plurality of single color transfer materials is a step in which a plastic deformation layer is formed on the transfer substrate, a releasing layer is formed on the plastic deformation layer, and a coloring material layer is formed on the releasing layer.

8. The method of producing a pattern member according to claim 3, wherein the step of forming a plurality of single color transfer materials is a step in which the plastic deformation layer, the releasing layer and the coloring material layer are overlapped and formed simultaneously.

9. The method of producing a pattern member according to claim 1 wherein the substrate is a transparent substrate.

10. The method of producing a pattern member according to claim 2 wherein the substrate is a transparent substrate.

11. The method of producing a pattern member according to claim 3 wherein the substrate is a transparent substrate.

12. The method of producing a pattern member according to claim 4 wherein the substrate is a transparent substrate.

13. The method of producing a pattern member according to claim 1, wherein the substrate is obtained by forming an electrode layer on a transparent substrate.

14. The method of producing a pattern member according to claim 2, wherein the substrate is obtained by forming an electrode layer on a transparent substrate.

15. The method of producing a pattern member according to claim 3, wherein the substrate is obtained by forming an electrode layer on a transparent substrate.

16. The method of producing a pattern member according to claim 4, wherein the substrate is obtained by forming an electrode layer on a transparent substrate.

17. A pattern member having a multi-color pattern made of color inks of a plurality of colors on a substrate, formed by repeating, at frequency corresponding to the number of the plurality of colors, an operation of overlapping a single color film of one color among single color films of a plurality of colors having a color ink layer formed on its surface by applying color inks of respective colors on a plurality of films and drying the color inks, on a given substrate such that the color ink layer of the single color film comes in contact with the substrate, and then, pressing the overlapped substrate and the single color film by a pressing member having a convex portion of given pattern formed on its surface, to transfer a portion corresponding to the pattern of the convex portion of the color ink layer to the substrate.

18. A pattern member having a multi-color pattern composed of a plurality of colors on a substrate, the pattern member being formed by repeating, at frequency corresponding to the number of the plurality of colors, an operation of pressing a surface of each single color transfer material having one of the plurality of colors formed by forming a coloring material layer of each color on each of a plurality of transfer materials, by a pressing member having irregularity of given pattern formed on its surface, to form an irregularity pattern corresponding to the irregularity of the pressing member on the surface of the single color transfer material, and then, overlapping the surface of the single color transfer material of one color among the single color transfer materials of the plurality of colors having an irregularity pattern formed on a given substrate, to transfer the coloring material layer at the convex portion of the single color transfer material to the substrate.
